# EUROPÄISCHE PATENTANMELDUNG

(11) **EP 1 093 205 A2**
(43) Veröffentlichungstag der Anmeldung: **18.04.2001**
(21) Anmeldenummer: 00121546.6
(22) Anmeldetag: 30.09.2000
(51) Int. Cl.: H02J 7/14, B60R 16/02

(54) **Vorrichtung zur Erkennung einer Unterbrechung der Ladeleitung zwischen einem Generator und einer Batterie eines Kraftfahrzeuges**

(30) Priorität: 12.10.1999 DE 19948968
(71) Anmelder: ROBERT BOSCH GMBH, 70442 Stuttgart (DE)
(72) Erfinder: Kohl, Walter, 74348 Lauffen (DE); Hiller, Burkhard, 71739 Oberriexingen (DE); Koss, Thomas, 72766 Reutlingen (DE)

(57) **Zusammenfassung**

Erfindungsgemäß wird eine Vorrichtung zur Erkennung einer Unterbrechung der Leitung zwischen einem Generator und einer Batterie eines Kraftfahrzeugs vorgeschlagen, bei der der Generator (1) über eine Schnittstelle (7) mit einem Steuergerät (3) für Motor- oder Fahrzeugfunktionen vorzugsweise bidirektional kommuniziert. Über die Schnittstelle (7) wird einerseits der Generator (1) gesteuert und andererseits die Last des Generators an der Klemme DF abgefragt. Da das Steuergerät (3) aus anderen Betriebsgründen bereits die Bordnetzspannung kennt, kann diese Spannung mit dem Sollwert für den Generator verglichen werden. Eine zusätzlich Sense-Leitung, wie sie beim Stand der Technik verwendet wird, ist nicht erforderlich. Je nach Ergebnis des Vergleichs wird eine entsprechende Anzeige (H1) gesteuert.

## Beschreibung

### Stand der Technik

Die Erfindung geht aus von einer Vorrichtung zur Erkennung einer Unterbrechung der Ladeleitung zwischen einem Generator und einer Batterie eines Kraftfahrzeugs nach der Gattung des Hauptanspruchs. Bei heutigen Generatoren wird zur Überwachung der Leitung zwischen dem Generator und der Batterie (Ladeleitung) bereits eine sogenannte Sense-Leitung verwendet, über die eine auftretende Spannungsdifferenz zwischen der Generatorausgangsspannung (Sollspannung) und der Bordnetzspannung (Batteriespannung) verglichen wird. So wird beispielsweise in der DE 33 13 398 C2 eine Vorrichtung zur Regelung eines Ladesystems für ein Kraftfahrzeug vorgeschlagen, durch Abgriff der am neutralen Punkt der Ankerwicklung erzeugten Spannung über eine separate Leitung oder auch alternativ durch Messung des Ausgangsstroms mittels eines Fühlers u.a. einen Bruch der Ladeleitung zu identifizieren. Diese zusätzliche Meßleitung bzw. der zusätzliche Stromfühler ist wegen der zusätzlichen Herstellungs- und Montagekosten unerwünscht und stellt im Betrieb ein gewisses Risiko für die Zuverlässigkeit dar, da auch diese Leitung brechen kann und dann gegebenenfalls ein funktionierender Generator vorgetäuscht wird, der unter Umständen keinen Strom mehr liefert, was zu einer schleichenden Entladung der Batterie während des Fahrbetriebs führen kann. Durch die Entladung der Batterie bricht das elektrische Bordnetz dann zusammen, so daß danach ein anschließender Start aus eigener Kraft nicht mehr möglich ist.

### Vorteile der Erfindung

Die erfindungsgemäße Vorrichtung zur Erkennung einer Unterbrechung der Ladeleitung mit den kennzeichnenden Merkmalen des Hauptanspruchs hat demgegenüber den Vorteil, daß weder eine zusätzliche Sense-Leitung noch ein Strommeß-Fühler erforderlich sind. Dadurch werden nicht nur Herstellungs- und Montagekosten eingespart, sondern auch die Zuverlässigkeit des Ladevorgangs der Batterie erhöht.

Als besonderer Vorteil wird angesehen, daß der Generator über die Schnittstelle von dem externen Steuergerät nicht nur in seiner Sollspannung steuerbar ist, sondern daß über die gleiche Schnittstelle auch Daten ausgelesen werden können, so daß dadurch ohne zusätzlichen Aufwand an Hardware die Ausgangsspannung des Generators erfaßbar ist. Durch Vergleich dieses Wertes mit der Bordnetzspannung ist eine einfache Diagnose für die Leitungsunterbrechung möglich.

Durch die in den abhängigen Ansprüchen aufgeführten Maßnahmen sind vorteilhafte Weiterbildungen und Verbesserungen der im Hauptanspruch angegebenen Vorrichtung möglich. Besonders vorteilhaft ist, daß die Bordnetzspannung von dem Steuergerät nicht zusätzlich gemessen wird, da sie bereits dem Steuergerät bekannt ist.

Da möglicherweise Störsignale die Meßergebnisse verfälschen können, ist es vorteilhaft, ein Warnsignal für eine Leitungsunterbrechung erst dann auszugeben, wenn ein bestimmter Schwellwert für die Differenz zwischen der Bordnetzspannung und der Sollspannung des Generators vorliegt.

Ein sicherer Indikator für die Feststellung einer Leitungsunterbrechung ist auch die Generatorlast, die über die Schnittstelle erfaßt werden kann. Wenn ein Verbraucher eingeschaltet wird, muß also immer ein bestimmter Ladestrom aus dem Generator fließen. Liegt dieser Wert unter dem vorgegebenen Schwellwert, kann davon ausgegangen werden, daß eine Störung vorliegen muß. In diesem Fall kann ein Warnsignal, beispielsweise in Form einer Leuchte am Armaturenbrett oder ein akustisches Signal ausgegeben werden.

Um eine Unterbrechung der Ladeleitung und natürlich auch der zugehörigen Minusleitung eindeutig zu identifizieren, muß ausgeschlossen werden, daß andere Fehler, beispielsweise ein Störfall im Generator, ausgeschlossen werden. Durch Verknüpfung mehrerer Parameter wird erreicht, daß die Ursache für die Unterbrechung genau feststellbar ist, ohne daß zusätzliche Untersuchungen notwendig sind.

Als Vorteil wird auch angesehen, daß der Fehler gespeichert wird, so daß beim nächsten Werkstattbesuch der aufgetretene Fehler überprüft werden kann. Dies ist um so einfacher, wenn er beispielsweise auf dem Armaturenbrett angezeigt oder über einen Adapter auslesbar ist.

### Zeichnung

Ein Ausführungsbeispiel der Erfindung ist in der Zeichnung dargestellt und in der nachfolgenden Beschreibung näher erläutert.

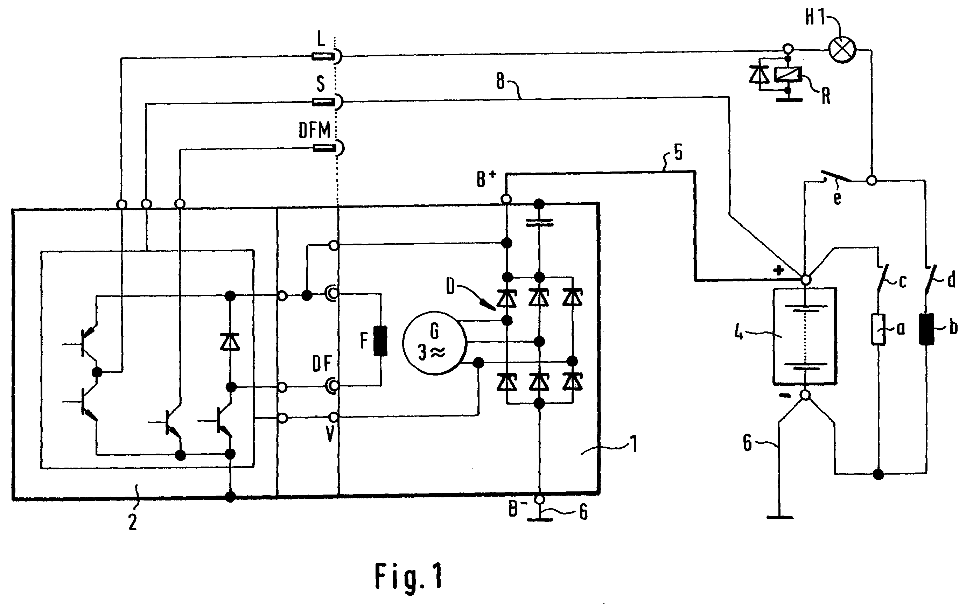

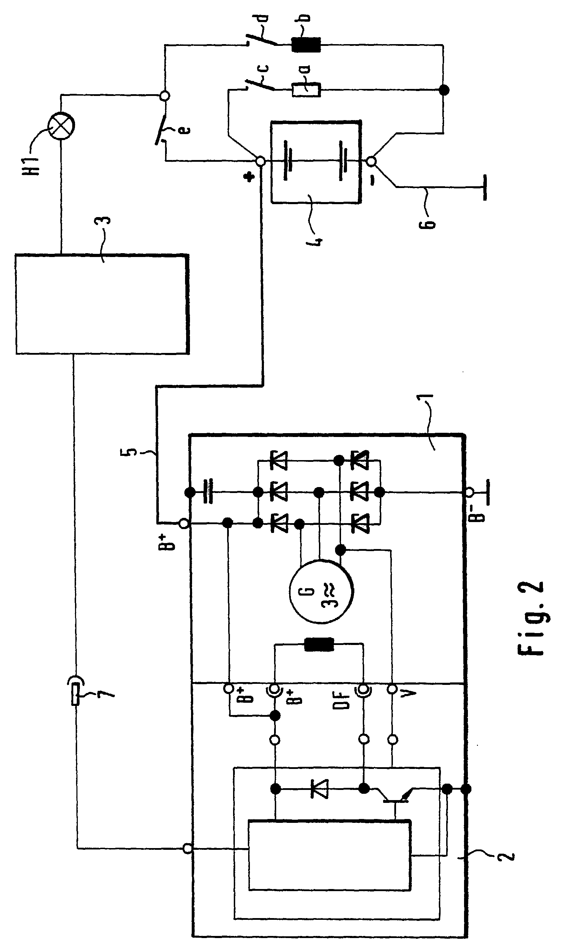

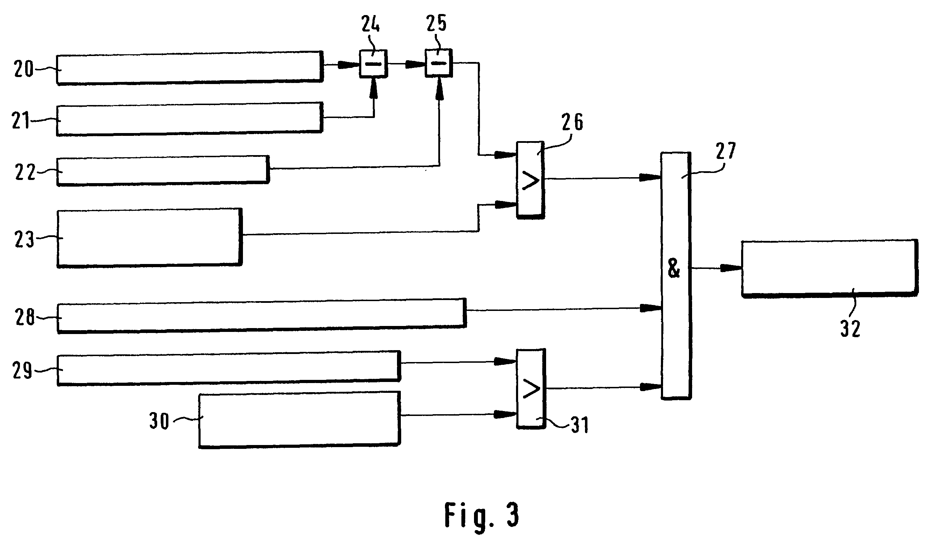

Figur 1 zeigt einen Stromlaufplan nach dem Stand der Technik, Figur 2 zeigt einen Stromlaufplan eines Ausführungsbeispiels und Figur 3 zeigt ein Flußdiagramm.

### Beschreibung des Ausführungsbeispiels

Zum besseren Verständnis der Erfindung wird zunächst anhand der Figur 1 beschrieben, wie bisher ein Bruch der Ladeleitung 5 sowie der zugehörigen Masseverbindung 6 zwischen einem Generator 1 und einer Batterie 4 detektiert wurde. In Figur 1 ist ein bekannter Generator 1 als Drehstromgenerator mit dem Rotor G und der Feldwicklung F sowie den Gleichrichterdioden D dargestellt. Der Generator 1 wird im allgemeinen von einem Riementrieb des Verbrennungsmotors angetrieben und erzeugt je nach dem Erregungsgrad der Feldwicklung F über die Klemme DF an der Ausgangsklemme B+ einen Ladestrom für eine Batterie 4. Die Regelung der Ausgangsspannung an der Klemme B+ erfolgt dabei in der Regel mittels eines Spannungsreglers (Regler 2). Dem Regler 2 wird dabei über eine Sense-Leitung 8 die Batteriespannung zugeführt. Über eine Klemme DFM läßt sich dann die Erregerspannung und die Last des Generators 1 messen. Aus Gründen der Vollständigkeit sind noch eine übliche Kontrolleuchte H1 sowie ein Steuerrelais R mit Kontakten und Widerständen a bis e dargestellt. Die Kontrolleuchte H1 ist über einen Anschluß L mit dem Regler 2 verbunden. Ein Bruch der Ladeleitung 5, 6 oder auch hochohmige Kontakte werden dadurch erkannt, daß die über die Sense-Leitung 8 gemessene Spannung der Batterie mit dem DF-Signal, das der Generatorspannung entspricht, verglichen wird. Bei Abweichung über einen vorgegebenen Schwellwert wird die Kontrolleuchte H1 über das Relais R geschaltet.

Beim Ausführungsbeispiel der Erfindung gemäß der Figur 2 wird dabei von einem ähnlichen Aufbau von Generator 1, Regler 2, der Batterie 4 sowie der Ladeleitung 5, 6 ausgegangen. Wie in Figur 1 wurde der Regler 2 zusammen mit dem Generator 1 gezeichnet, da der Regler 2 in der Regel auf dem Gehäuse des Generators 1 montiert ist.

Anstelle der Anschlüsse L, Sense, DFM - gemäß der Figur 1 - enthält nun der Regler 2 bzw. der Generator 1 eine Schnittstelle 7, die mit einem Steuergerät 3 verbunden ist, das ohnehin für Motor- oder Fahrzeugsteuerungen vorhanden ist. Die Schnittstelle 7 ist vorzugsweise als digitale, bidirektionale Schnittstelle ausgebildet. Über sie kann das Steuergerät 3 sowohl Daten an den Regler 2 bzw. den Generator 1 senden als auch Daten über den Betriebszustand des Generators 1 abfragen. Dadurch ist es möglich, durch Abfragen der Spannung an der Klemme DF, die ein Indikator für die Last des Generators ist, und durch den Vergleich mit der Bordnetzspannung, die ohnehin aus anderen Gründen bereits im Steuergerät 3 zur Verfügung steht, Rückschlüsse über den Betriebszustand des Generators 1 zu ziehen und einen Bruch der Ladeleitung 5, 6 zu identifizieren. Aus Gründen der Vollständigkeit wird noch darauf hingewiesen, daß das Steuergerät 3 mit einer Anzeige verbunden ist, die in einfachster Ausführung wieder die bekannte Kontrolleuchte H1 sein kann. Diese Kontrolleuchte wird im Fehlerfall vom Steuergerät 3 betätigt. Selbstverständlich sind auch andere Anzeigen wie Symbole, LCD-Anzeigen oder Hinweise in Klartext vorsehbar.

Im folgenden wird anhand der Figur 3 die Funktionsweise dieser Anordnung näher erläutert. Da keine Sense-Leitung mehr erforderlich ist, erfolgt die Kommunikation mit dem Steuergerät 3 nur über die Schnittstelle 7. Die Generatorsollspannung wird vom Steuergerät 3 über die Schnittstelle 7 dem Regler 2 bzw. Generator 1 vorgegeben (Position 20). Von dieser wird der Spannungsabfalls des Bordnetzes (Position 21) in Position 24 subtrahiert. Der Spannungsabfall des Bordnetzes muß einmal für die Stelle bestimmt werden, an der sich das Steuergerät 3 befindet und in den Generator eingegeben werden. Von der verbleibenden Spannung wird in Position 25 die Batteriespannung (Position 22) abgezogen und das Ergebnis mit einem ersten appliziebaren Schwellwert (Position 23) verglichen.

Liegt die Differenz unterhalb des vorgegebenen Schwellwertes (Position 23), dann kann von einem Fehler ausgegangen werden. Allerdings ist dabei noch nicht eindeutig, ob dieser Fehler durch einen Bruch der Ladeleitung 5, 6 verursacht ist. Da auch ein elektrischer Generatorfehler (Position 28) vorliegen kann, wird in weiterer Ausgestaltung der Erfindung dieser ebenfalls erfaßt (Position 27). Des weiteren wird die Generatorlast, die an der Klemme DF ermittelt wird (Position 29) gemessen und unter Berücksichtigung eines weiteren applizierbaren Schwellwertes (Position 30, 31) in der Position 27 mit verknüpft. Je nach den vorliegenden Ergebnissen kann darauf geschlossen werden, daß die Ladeleitung 5, 6 unterbrochen ist oder ein elektrischer Generatorfehler vorliegt (Position 32). Dieses Ergebnis wird entsprechend angezeigt.

Zur genauen Identifizierung eines Bruchs der Ladeleitung oder dem Vorliegen eines elektrischen Fehlers des Generators 1 sind also zusammengefaßt folgende Bedingungen zu prüfen:
a) Die Generatorsollspannung an der Klemme B+ muß größer sein als die Batteriespannung zusammen mit dem Spannungsabfall zwischen dem Generator und dem Meßpunkt im Steuergerät sowie einem ersten Schwellwert, der als Sicherheitsabstand hinzugefügt wird.
b) Es darf kein elektrischer Generatorfehler vorliegen, der über die Schnittstelle 7 auslesbar ist.
c) Die Generatorlast, die über die Klemme DF am Generator bzw. Regler ebenfalls über die Schnittstelle 7 erfaßbar ist, darf eine sehr niedrige Schwelle nicht überschreiten.

Die Erklärung dieser Forderungen findet darin ihre Begründung, daß in Folge des fehlenden Ladestroms die Batterie 4 wegen der angeschlossenen Verbraucher nach und nach entladen wird und die Netzversorgungsspannung sinkt. Diese weicht zunehmend von der des Steuergerätes 3 vorgegebenen Generatorsollspannung ab. Überschreitet die Differenz eine erste Schwelle, ist die Bedingung a) erfüllt.

Die Bedingung b) ist erfüllt, wenn der Generator funktionsfähig ist, was in der Regel vorausgesetzt werden kann. Die Erfüllung dieser Bedingung stellt daher eine rein praktische Vorgehensweise dar, die alternativ wählbar ist.

Bezüglich der Bedingung c) wird davon ausgegangen, daß bei einer unterbrochenen Ladeleitung die elektrische Last für den Generator 1 sehr gering ist, da bei einer gebrochenen Ladeleitung 5, 6 kein Strom fließt. Das Signal an der Klemme DF ist daher sehr klein, d.h. praktisch Null. Um dieses Signal von einer intakten Ladeleitung mit minimaler elektrischer Generatorlast zu unterscheiden, wird ein zweiter Schwellwert vorgegeben, der nicht überschritten werden darf.

In weiterer Ausgestaltung der Erfindung ist vorgesehen, einen erkannten Fehler zu speichern, so daß er beim nächsten Service mit den bekannten Diagnoseverfahren feststellbar ist. Dabei wird vorteilhaft die Fehlersuche und gegebenenfalls die Reparatur vereinfacht. Nach erfolgter Reparatur kann dann der Inhalt des Fehlerspeichers gelöscht werden, so daß er für einen neuen Fehler wieder bereitsteht.

## Patentansprüche

1. Vorrichtung zur Erkennung einer Unterbrechung der Ladeleitung (5, 6) zwischen einem Generator (1) und einer Batterie (4) eines Kraftfahrzeugs, mit einen Generator (1), einer Batterie (4), einer Ladeleitung (5, 6) und mit einem Regler (2) für die Sollspannung des Generators (1), dadurch gekennzeichnet, daß der Generator (1) eine Schnittstelle (7) aufweist, über die Signale vorgebbar und/oder Daten auslesbar sind, daß der Generator (1) über die Schnittstelle (7) mit einem Steuergerät (3) für Motor- oder Fahrzeugfunktionen verbunden ist, und daß das Steuergerät (3) ausgebildet ist, durch Verknüpfung mit wenigstens einem Parameter des Generators (1) eine Unterbrechung der Ladeleitung (5, 6) zu erkennen.

2. Vorrichtung nach Anspruch 1, dadurch gekennzeichnet, daß das Steuergerät (3) Mittel aufweist, die Bordnetzspannung zu messen.

3. Vorrichtung nach Anspruch 1 oder 2, dadurch gekennzeichnet, daß das Steuergerät (3) ausgebildet ist, bei Überschreiten eines ersten Schwellwertes für die Differenz aus der Bordnetzspannung und der Solispannung des Generators ein Signal abzugeben.

4. Vorrichtung nach einem der vorherigen Ansprüche, dadurch gekennzeichnet, daß das Steuergerät (3) ausgebildet ist, als Parameter die Generatorlast zu ermitteln.

5. Steuergerät nach Anspruch 4, dadurch gekennzeichnet, daß das Steuergerät (3) ausgebildet ist, bei nicht Erreichen eines zweiten Schwellwertes für die Generatorlast ein Signal für die Unterbrechung der Ladeleitung (5, 6) auszugeben.

6. Vorrichtung nach einem der vorherigen Ansprüche, dadurch gekennzeichnet, daß das Steuergerät (3) bei Nichterfüllung der drei Parameter:
a) Sollspannung des Generators (3) ist größer als die Summe aus Bordnetzspannung und einem vorgegebenen ersten Schwellwert,
b) es liegt kein Generatorfehler vor und
c) die Generatorlast überschreitet nicht eine vorgegebene niedrige zweite Schwelle.

7. Vorrichtung nach einem der vorherigen Ansprüche, dadurch gekennzeichnet, daß das Steuergerät (3) ausgebildet ist, bei Feststellung einer Unterbrechung der Ladeleitung (5, 6) den Fehler zu speichern.

8. Vorrichtung nach einem der vorherigen Ansprüche, dadurch gekennzeichnet, daß der Fehler auf einer Anzeige im Armaturenbrett oder über einen elektrischen Anschluß ausgebbar ist.
